Europäisches Patentamt

European Patent Office

Office européen des brevets

(11) Numéro de publication: **0 275 223 B1**

# FASCICULE DE BREVET EUROPEEN

(45) Date de publication de fascicule du brevet: **15.07.92** (51) Int. Cl.⁵: **H03K 3/30**, H02M 3/338

(21) Numéro de dépôt: **88400050.6**

(22) Date de dépôt: **11.01.88**

(54) **Circuit générateur de haute tension à très faible consommation de courant.**

(30) Priorité: **15.01.87 FR 8700377**

(43) Date de publication de la demande:
**20.07.88 Bulletin 88/29**

(45) Mention de la délivrance du brevet:
**15.07.92 Bulletin 92/29**

(84) Etats contractants désignés:
**AT BE CH DE ES FR GB IT LI LU NL SE**

(56) Documents cités:
**WO-A-85/04483**
**GB-A- 1 513 190**
**US-A- 3 681 711**

(73) Titulaire: **P.G.E.P. PROFESSIONAL GENERAL
ELECTRONIC PRODUCTS Société Anonyme
130 rue Jean-Pierre Timbaud
F-92400 Courbevoie(FR)**

(72) Inventeur: **Blanchot, Michèle
130, rue Jean-Pierre Timbaud
F-92400 Courbevoie(FR)**
Inventeur: **Dutertre-Ladurée, Daniel
17, rue Mojard Cravent
F-78270 Bonnieres-Sur-Seine(FR)**
Inventeur: **Ross, Rein André
La Pichotière
F-61340 Nocé(FR)**

(74) Mandataire: **Laget, Jean-Loup et al
Cabinet Pierre Loyer 77, rue Boissière
F-75116 Paris(FR)**

## Description

L'invention concerne un circuit générateur de haute tension, à très faible consommation de courant, par exemple pour détecteur de particules.

Il est connu, par le document FR-A-2.561.778, de réaliser un détecteur de particules fonctionnant avec une intensité de l'ordre du pico-ampère. Un détecteur de de ce type doit avoir ses électrodes soumises à une haute tension continue comprise de préférence entre 1.000 et 4.000 V.

Le document US-A-3.681.711 décrit un circuit générateur de haute tension à transformateur élévateur de tension, dont le primaire est alimenté par un transistor contrôlé au moyen d'un circuit à résistance et capacité. A chaque période de conduction du primaire, le secondaire provoque une inversion de la polarité de la capacité.

Le document GB-A-1.513.190 décrit un circuit générateur de haute tension à transformateur, dont le primaire est alimenté par l'intermédiaire d'un montage de Darlington dont le transistor de commande est contrôlé au moyen d'un circuit à résistance et capacité.

Un but de la présente invention est de proposer un circuit générateur de haute tension capable de fournir une tension de 1.000 à 4.000 V environ sous volume réduit et avec une très faible consommation de courant, à partir d'une tension de polarisation de 10 V environ.

L'invention a pour objet un circuit générateur de haute tension continue, à très faible consommation, du type comportant :

- un transformateur élévateur de tension, constitué d'une bobine primaire et d'une bobine secondaire,
- la bobine primaire étant montée en série avec un transistor de puissance contrôlé par un transistor de commande, la base du transistor de commande étant reliée au point milieu d'un circuit à résistance et capacité, dont la capacité est connectée en parallèle à l'entrée du transistor de commande,
- la bobine secondaire étant montée en série avec un détecteur de particules à deux électrodes,
- un circuit élévateur de tension étant monté en série entre la bobine secondaire et le détecteur de particules, caractérisé en ce que :
- un couplage capacitif est prévu entre d'une part le point commun à la bobine secondaire et au circuit élévateur de tension , et d'autre part ledit point milieu du circuit à résistance et capacité, pour inverser , à chaque coupure de la conduction du primaire, la polarité du point milieu du circuit à résistance et capacité de façon à verrouiller le blocage des transistors.

Selon des modes de réalisation particuliers de l'invention :

- le courant moyen dans le primaire est inférieur à 100μA alors que, pendant les périodes de conduction du transistor de puissance le courant dans le primaire est de l'ordre de 1A ;
- la durée des périodes de conduction du primaire est de l'ordre de la μs et la durée séparant deux périodes de conduction successives est de l'ordre de quelques ms ;
- la haute tension continue appliquée au détecteur de particules est de quelques milliers de volts.

D'autres caractéristiques ressortent de la description qui suit faite avec référence au dessin annexé sur lequel on peut voir :

Figure 1 : un schéma du circuit générateur de haute tension selon l'invention appliqué à un détecteur de particules ;

Figure 2 : un exemple de réalisation d'un circuit élévateur de tension utilisable dans le circuit de la figure 1.

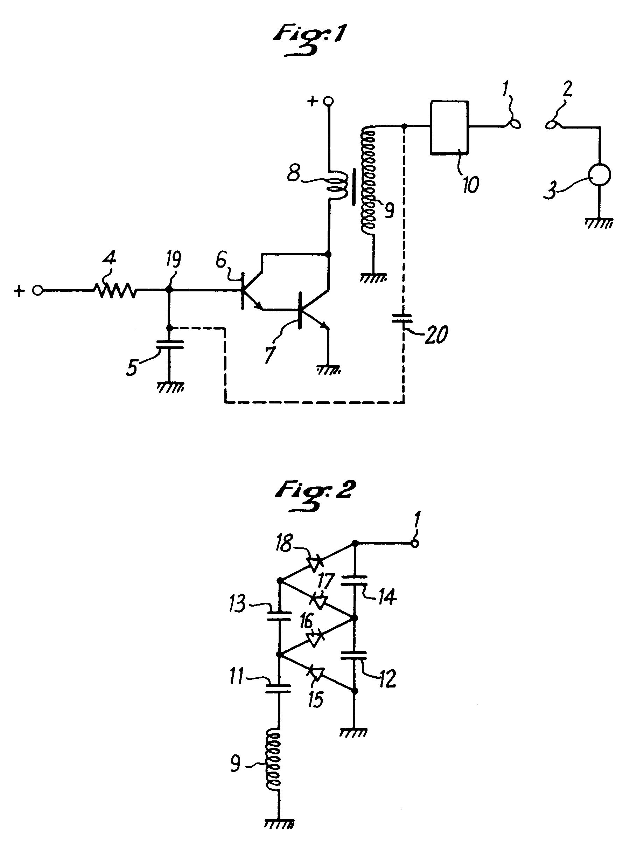

En se reportant à la figure 1, on voit un détecteur de particules constitué essentiellement de deux électrodes 1 et 2 dont l'une 1 est alimentée en haute tension par le circuit selon l'invention et dont l'autre 2 est reliée à la masse par l'intermédiaire d'un galvonomètre 3. Le circuit générateur de haute tension comprend essentiellement un circuit RC à résistance 4 et capacité 5 en série, deux transistors 6, 7, un transformateur à primaire 8 et secondaire 9 et un circuit élévateur de tension 10.

Le circuit RC et le primaire 8 du transformateur sont alimentés par une tension de polarisation de l'ordre de 5 à 20 V. La capacité 5 est reliée à la masse. Le point milieu 19 du circuit RC est relié à la base du transistor 6 de commande du transistor de puissance 7. Le primaire 8 du transformateur est monté en série avec le transistor de puissance 7. Le secondaire 9 du transformateur est branché entre, d'une part, la masse et, d'autre part, le circuit élévateur de tension 10 qui alimente l'électrode 1 en haute tension.

Dans un exemple particulier de réalisation, la résistance 4 est de l'ordre de 20 MΩ, la capacité 5 est de l'ordre de 470 pF, le primaire 8 a environ 20 spires et le secondaire de 500 à 1000 spires. La figure 2 montre un exemple de réalisation d'un circuit 10 élévateur de tension de type classique à capacités 11, 12, 13, 14 et diodes 15, 16, 17, 18.

Dans l'exemple de réalisation de la figure 1, la constante de temps du circuit RC pour la charge de la capacité 5 est de l'ordre de quelques ms, et la durée de conduction à fort courant (de l'ordre de 1A) du transistor 7 est de l'ordre de la μs.

Le fonctionnement du circuit générateur de haute tension s'analyse de la manière suivante : la capacité 5 se charge pendant quelques ms ; le potentiel du point milieu 19 du circuit RC, relié à la base du transistor de commande 6 atteint alors le seuil de conduction de ce transistor 6 qui devient conducteur et déclenche la conduction du transistor de puissance 7 ; le transistor 7 se met à conduire et le primaire 8 du transformateur est alimenté en courant ; le primaire 8, avec sa capacité parasite, se comporte en oscillateur et une demi-onde positive de courant traverse le primaire et le transistor 7 ; à la fin de cette demi-onde, qui a duré environ 1$\mu$s, le potentiel du collecteur du transistor 7 et le potentiel de base du transistor 7 deviennent négatifs et le transistor 7 se bloque ; pendant la conduction du transistor 7, une tension induite a pris naissance au secondaire 9, dont l'amplitude est fonction de la tension de polarisation au primaire et du rapport des nombres de spires au secondaire et au primaire ; cette tension est appliquée au circuit élévateur de tension 10 ; à la coupure de la conduction au primaire, le secondaire 9, avec sa capacité parasite, se comporte en oscillateur et une tension oscillante amortie se superpose à la tension induite par le primaire ; la première demi-onde négative de cette tension oscillante provoque, par le couplage symbolisé en 20, par exemple un couplage capacitif, une inversion de la polarité du point milieu 19 du circuit RC du primaire, qui devient négative, et qui verrouille le blocage des transistors 6 et 7.

Le processus de charge de la capacité 5 recommence alors pendant 10 ms environ, jusqu'à un nouveau déclenchement de la conduction des transistors du primaire pour une durée d'environ 1 $\mu$s , et ainsi de suite, ce qui assure la montée en tension de l'électrode 1 et le maintien d'une tension élevée sur cette électrode.

Il faut noter que le secondaire 9, avec sa capacité parasite, se comporte en oscillateur à haute fréquence. L'oscillation du secondaire est amortie par sa résistance propre qui influe sur l'amplitude de cette oscillation. En outre, le circuit élévateur de tension 10 a un courant de fuite de l'ordre de 1nA, dû essentiellement aux fuites dans les condensateurs 11-14 et dans les diodes 15-18. L'impédance correspondant aux fuites dans ce circuit affecte donc l'amplitude des tensions engendrées dans le secondaire. Par ailleurs, le détecteur de particules constitué par les électrodes 1, 2 et le galvanomètre 3 a une particularité : la présence de particules entraîne un accroissement du courant entre les électrodes 1 et 2. Cette augmentation du courant dans le détecteur diminue aussi l'amplitude des tensions engendrées dans le secondaire. Il en résulte que la polarisation négative appliquée au point 19 du primaire par le couplage 20 est d'amplitude plus faible. De ce fait, le temps de recharge de la capacité 5 devient plus court et l'intervalle entre deux périodes de conduction du primaire devient aussi plus court, ce qui permet de maintenir la haute tension sur l'électrode 1 à son niveau élevé : on constate une auto-régulation de la haute tension.

Le circuit générateur de haute tension selon la présente invention est remarquable par sa simplicité, son faible encombrement (quelques centimètres cubes),et sa faible consommation de puissance moyenne. En effet, bien que, pendant les périodes de conduction du primaire, le courant primaire soit de l'ordre de 1A, le courant moyen primaire est de l'ordre de 100 $\mu$A. Dans les générateurs de haute tension à oscillateur bloqué, de type classique, le courant moyen primaire est de l'ordre de 100 mA, c'est-à-dire 1000 fois plus important.

Enfin, le circuit générateur de haute tension selon l'invention permet de disposer sur l'électrode 1 du détecteur de particules, d'une tension continue d'une valeur de quelques milliers de volts. La valeur de cette tension est déterminée par la valeur de la tension de polarisation du primaire, par le rapport des nombres de spires au secondaire et au primaire, et par la structure du circuit élévateur de tension 10.

Le circuit générateur de haute tension selon l'invention est d'autant plus efficace que ses dimensions sont réduites.

Il est applicable aux appareils qui ont besoin d'une haute tension et qui ont une consommation de courant très faible, par exemple les détecteurs de particules pour la détection de fumées ou de gaz, les détecteurs de vapeurs (de sodium par exemple), de poussières, d'aérosols ou d'ions, les filtres activés pour masques respiratoires, les lunettes à infra-rouges, ou les purificateurs d'air, sans que cette liste soit limitative.

## Revendications

1. Circuit générateur de haute tension continue, à très faible consommation, du type comportant :
   - un transformateur élévateur de tension, constitué d'une bobine primaire (8) et d'une bobine secondaire (9),
   - la bobine primaire (8) étant montée en série avec un transistor (7) de puissance contrôlé par un transistor (6) de commande, la base du transistor (6) de commande étant reliée au point milieu (19) d'un circuit à résistance (4) et capacité (5), dont la capacité (5) est connectée en parallèle à l'entrée du transistor (6) de commande,
   - la bobine secondaire (9) étant montée en série avec un détecteur de particules à deux électrodes (1, 2),

- un circuit élévateur de tension (10) étant monté en série entre la bobine secondaire (9) et le détecteur de particules, caractérisé en ce que :
- un couplage capacitif est prévu entre d'une part le point commun à la bobine secondaire (9) et au circuit élévateur de tension (10), et d'autre part ledit point milieu (19) du circuit à résistance (4) et capacité (5), pour inverser , à chaque coupure de la conduction du primaire, la polarité du point milieu (19) du circuit à résistance (4) et capacité (5) de façon à verrouiller le blocage des transistors (6,7).

2. Circuit selon la revendication 1, caractérisé en ce que le courant moyen dans le primaire (8) est inférieur à 100μA alors que, pendant les périodes de conduction du transistor de puissance (7) le courant dans le primaire (8) est de l'ordre de 1A.

3. Circuit selon la revendication 2, caractérisé en ce que la durée des périodes de conduction du primaire (8) est de l'ordre de la μs et la durée séparant deux périodes de conduction successives est de l'ordre de quelques ms.

4. Circuit selon la revendication 3, caractérisé en ce que la haute tension continue appliquée au détecteur de particules est de quelques milliers de volts.

## Claims

1. A high DC voltage generator circuit having very low power consumption, of the type comprising:
   - a step-up transformer, formed of a primary coil (8) and a secondary coil (9),
   - the primary coil (8) being connected in series with a power transistor (7) controlled by a control transistor (6), the base of the control transistor (6) being connected to the mid-point (19) of a resistance (4) and capacitance (5) circuit, the capacitance (5) of which is connected in parallel to the input of the control transistor (6),
   - the secondary coil (9) being connected in series with a dual-electrode particle detector (1, 2),
   - a voltage-increasing circuit (10) being connected in series between the secondary coil (9) and the particle detector, characterised in that:
   - a capacitive coupling is provided between firstly the point common to the secondary coil (9) and to the voltage-increasing circuit (10), and secondly said midpoint (19) of the resistance (4) and capacitance (5) circuit, to reverse the polarity of the mid-point (19) of the resistance (4) and capacitance (5) circuit at each interruption of the conduction of the primary so as to lock the blocking of the transistors (6, 7).

2. A circuit according to Claim 1, characterised in that the average current within the primary (8) is less than 100 μA, whereas, during the periods of conduction of the power transistor (7) the current in the primary (8) is of the order of 1 A.

3. A circuit according to Claim 2, characterised in that the duration of the periods of conduction of the primary (8) is of the order of one μs and the duration separating two successive periods of conduction is of the order of several ms.

4. A circuit according to Claim 3, characterised in that the high DC applied to the particle detector is several thousand volts.

## Patentansprüche

1. Hochspannungsgeneratorschaltung mit sehr geringem Stromverbrauch mit:
   - einem Hochspannungstransformator, der aus einer Primärspule (8) und einer Sekundärspule (9) besteht,
   - wobei die Primärspule (8) mit einem Leistungstransistor (7) in Serie geschaltet ist, der durch einen Steuertransistor (6) gesteuert wird, wobei die Basis des Steuertransistors (6) mit einem Mittelpunkt (19) einer Schaltung aus Widerstand (4) und Kondensator (5) verbunden ist, bei der der Kondensator (5) parallel zu dem Eingang des Steuertransistors (6) angeschlossen ist,
   - wobei die Sekundärspule (9) in Serie mit einem Partikeldetektor mit zwei Elektroden (1, 2) geschaltet ist,
   - einer Spannungserhöhungsschaltung (10), die in Serie zwischen die Sekundärspule (9) und den Partikeldetektor geschaltet ist, dadurch gekennzeichnet, daß:
   - eine kapazitive Kopplung zwischen der Verbindung von Sekundärspule (9) und Spannungserhöhungsschaltung (10) und andererseits dem Mittelpunkt (19) der Schaltung mit Widerstand (4) und Kondensator (5) vorgesehen ist, um bei jeder Unterbrechung der Leitfähigkeit des Primärkreises die Polarität des Mittelpunkts (19) der Schaltung mit Widerstand (4) und Kondensator (5) umzukehren, um dergestalt die Blockierung der Transistoren (6, 7) zu verriegeln.

2. Schaltung nach Anspruch 1, dadurch gekennzeichnet, daß der mittlere Strom in der Primärspule (8) weniger als 100 $\mu$A beträgt, während jedoch während der Perioden, in denen der Leistungstransistor (7) leitet, der Strom in der Primärspule (8) in der Größenordnung von 1A liegt.

3. Schaltung nach Anspruch 2, dadurch gekennzeichnet, daß die Dauer des Stromflusses in der Primärspule (8) in der Größenordnung von 1 $\mu$s liegt, und die Zeitdauer, die zwei aufeinanderfolgende Stromflußperioden trennt, in der Größenordnung von einigen Millisekunden liegt.

4. Schaltung nach Anspruch 3, dadurch gekennzeichnet, daß die hohe Gleichspannung, die an dem Partikeldetektor angelegt ist, einige tausend Volt beträgt.

Fig. 1

Fig. 2